# EUROPEAN PATENT APPLICATION

(11) **EP 2 806 562 A1**
(43) Date of publication of application: **26.11.2014**
(21) Application number: 13305661.4
(22) Date of filing: 22.05.2013
(51) Int. Cl.: H03K 21/00, H03K 23/00

(54) **Programmable frequency divider module with duty cycle close to fifty percent**

(71) Applicant: Asahi Kasei Microdevices Corporation, Tokyo 101-8101 (JP)
(72) Inventor: Canard, David, 14460 Colombelles (FR); Gervais, Didier, 14460 Colombelles (FR)
(74) Representative: Cabinet Plasseraud

(57) **Abstract**

A programmable frequency divider module (10) is based on a programmable re-load counter (1) and a digital combination (11) comprising an N-bit adder. In a preferred implementation, a down-count from a division ratio value (R) down to one-value is repeated, and a down-count signal is added to an offset value itself determined as a function of the division ratio value. The adder carry generates a derived clock signal having a frequency equal to that of an initial clock signal divided by the division ratio value. Such frequency divider module produces the derived clock signal with low noise and duty cycle close to 50%. It is well adapted in particular for clocking analog-to-digital converters, digital-to-analog converters and phase-locked loop devices.

## Description

The invention relates to a programmable frequency divider module which is suitable for delivering a clock signal having a duty cycle close to fifty percent.

### -- BACKGROUND OF THE INVENTION --

Electronic circuits need clocks for synchronizing the operations of all their internal blocks. But different blocks within one and same electronic circuit may need different respective clock frequencies, so that several synthesized frequencies are required within the whole circuit. Therefore, it is appropriate to provide several frequency synthesizers of same type but being programmable, so that the required frequencies can be all synthesized from one initial clock signal using division ratio values which are different from one another, respectively within the frequency synthesizers.

Depending on the blocks within the electronic circuit, some of them may require that the synthesized frequencies have low-noise.

There are also blocks with operation which is based in part on the rising edges of the clock signal which is synthesized, but also based in part on its falling edges. Then, for correct operation, the rising and falling edges have to be sufficiently separated in time within the synthesized clock signal. Put another way, the duty cycle of the synthesized clock signal which is delivered by each frequency synthesizer should be about 50%, for example comprised between 35% and 65%.

In particular, the quality of frequency synthesizers in term of duty cycle value is important for data converters, digital-to-analog ones or reverse, and for PLL devices.

Then, one object of the invention consists in providing a frequency synthesizer which is programmable, with duty cycle value of the signal synthesized which is constant and preferably comprised between 35% and 65%.

Another object of the invention is that the clock signal which is delivered by the frequency synthesizer has low-noise

Still another object of the invention is that the frequency synthesizer is low-cost and easy to implement within an electronic integrated circuit.

### -- SUMMARY OF THE INVENTION --

For meeting at least one of these objects or others, a first aspect of the invention proposes a programmable frequency divider module which comprises:
- a clock input, which is intended for receiving an initial clock signal having an initial frequency;
- a ratio input, which is intended for receiving an integer division ratio value greater than two; and
- a clock output, for delivering a derived clock signal having a synthesized frequency which equals the initial frequency divided by the division ratio value.

The invention frequency divider module further comprises, with N being an integer greater than unity:
- a programmable re-load counter, which is connected at counter inputs respectively to the clock input and the ratio input, and adapted for outputting repeatedly an integer count signal running between the one-value and the division ratio value, these values included, and the count signal being clocked according to the initial clock signal;
- a first intermediate N-bus, which is arranged for forwarding the count signal encoded over N bits;
- a second intermediate N-bus, which is connected at entrance to the ratio input for receiving the division ratio value encoded over N bits;
- a digital combination which comprises an N-bit adder, with first and second inputs of the digital combination which are connected respectively to exits of the first and second intermediate N-buses, and the digital combination being suitable for delivering at output a digital signal comprised alternatively of one out of two values depending on a comparison between at least one threshold and a result of an addition performed by the N-bit adder based on the count signal; and
- a D-flipflop which has a data input, a synchronization input and a flipflop output, with the data input connected to an output of the digital combination for receiving the digital signal, the synchronization input connected to the clock input, and the flipflop output connected to the clock output.

Because the division ratio value can be inputted from externally, the invention frequency divider module is of programmable type.

Also, the derived clock signal exhibits low-noise, in particular thanks to using the D-flipflop for re-synchronizing this derived clock signal before it is delivered at the clock output. Generally, an advantage of the invention frequency divider module is that it is fully synchronized with reference to only the initial clock signal.

Furthermore, the invention frequency divider module only implements components which are simple, easy to manufacture and low-cost.

In addition, by designing appropriately the digital combination which is implemented within the module, the duty cycle can be close to 50%, with sufficient time between successive falling and rising edges within the derived clock signal. In particular, the duty cycle can be comprised between 35% and 65%.

In some invention embodiments, the digital combination may comprise, further to the N-bit adder, at least one among a x-bit-right shifter, a y-bit-left shifter, a N-inverter and a digital comparator, x and y being non-zero integers less than N.

The programmable re-load counter may be a programmable re-load down-counter, so that the count signal is then a down-count signal which decreases from the division ratio value and repeats back from this division ratio value after the one-value has been reached.

When such programmable re-load down-counter is used, a first adder input of the N-bit adder may be connected to the exit of the first intermediate N-bus, and the digital combination may comprise further to the N-bit adder:
- a 1-bit-right shifter, which is connected at input to the exit of the second intermediate N-bus; and
- an N-inverter, which is connected downstream the shifter, and adapted for inverting each bit separately as originating from the shifter, the N-inverter thus producing an offset value and being connected at output to the second adder input.

With such design of the digital combination, the N-bit adder adds the down-count signal to the offset value. Because the offset value is based itself on the value of the division ratio, the duty cycle can be close to 50% whatever the value of the division ratio.

In preferred embodiments which are based on such design, the N-bit adder may be provided with a carry output for delivering a carry which forms the digital signal. This carry equals a first value when the addition result of the down-count signal with the offset value is less than 2N, and otherwise equals a second value different from the first one. In such invention embodiments, 2N is the comparison threshold involved earlier here-above.

Optionally, the programmable frequency divider module of the invention may further comprise a frequency two-divider unit connected at input to the clock output, and suitable for producing a final clock signal which is based on the derived clock signal and has a final frequency equal to half the synthesized frequency. Thus, the invention provides the final clock signal with final frequency equalling the initial one divided by two times the division ratio value.

A second aspect of the invention proposes an electronic circuit which comprises:
- a clock module which is adapted for producing the initial clock signal having the initial frequency;
- at least one programmable frequency divider module according to the first invention aspect, with the clock input which is connected to the clock module for receiving the initial clock signal; and
- at least one circuit block which is connected to the clock output of the programmable frequency divider module, so that this circuit block is clocked based on the derived clock signal.

The programmable frequency divider module and the circuit block may be contained within one and same integrated circuit chip, and the clock module may be external to this chip.

Finally, the invention suits specifically when the circuit block is selected from an analog-to-digital converter, a digital-to-analog converter and a phase-locked loop device.

### -- BRIEF DESCRIPTION OF THE DRAWINGS --

Figure 1 is a block diagram of a programmable frequency divider module according to the invention;
Figure 2 is a block diagram of a programmable frequency divider module according to one preferred embodiment of the invention;
Figures 3a to 3c are time-diagrams for explaining a base principle of a programmable frequency divider module in accordance with Figure 2;
Figure 4 is a diagram illustrating results obtained with a programmable frequency divider module in accordance with Figure 2; and
Figure 5 is a block diagram of an electronic circuit including a programmable frequency divider module according to the invention.

Same reference numbers which are indicated in different ones of these figures denote identical elements of elements with identical function. In addition, components with well-known functions and operation but not connected directly to the invention features are not described in detail.

### -- DETAILED DESCRIPTION OF THE INVENTION --

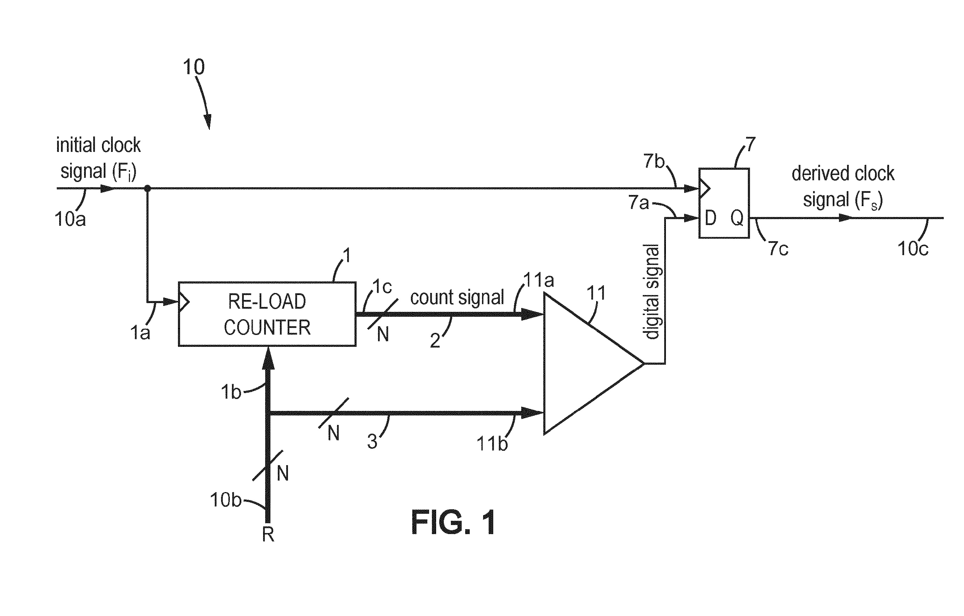

Referring to Figure 1, the reference numbers indicated therein have the following meanings:
1 programmable re-load counter, with counter inputs respectively labelled 1 a and 1 b, and counter output 1 c
2, 3 first and second intermediate N-buses, suitable for forwarding respective digital values each encoded over N bits 7 D-flipflop with 1-bit data input denoted D and labelled 7a, synchronization input 7b and Q-output 7c
10 frequency divider module as a whole, with clock input 10a, N-bit ratio input 10b and clock output 10c
11 digital combination, with first input 11a connected to the exit of the first intermediate N-bus 2, and second input 11 b connected to the exit of the second intermediate N-bus 3

The input 10a is to be fed from externally with an initial clock signal having initial frequency Fᵢ. Only for example purpose, the Fᵢ-frequency may be about 300 MHz (megahertz). The input 10b is to be fed with an integer value R for a division ratio, so that the output 10c delivers a derived clock signal with synthesized frequency Fₛ equal to Fᵢ divided by R. N is greater than unity, for example equal to four, and R is greater than two and encoded over N bits. Then, the Fₛ-frequency may be comprised between 20 and 100 MHz included, depending on the actual R-value.

The programmable re-load counter 1 may be either of up-counter type or down-counter type. Possibly, this counter-type itself may be programmed for a counter capable of operating alternatively according to both counter-types.

The digital combination 11 outputs a digital signal, for example a binary signal, based on the time-varying count signal which is transmitted by the intermediate N-bus 2. The digital combination 11 may have several designs, in particular depending on the counter-type which is actually selected for the programmable re-load counter 1. These designs implement an N-bit adder, and may further implement operators as bit-right shifters, bit-left shifters, N-inverters and/or digital comparators.

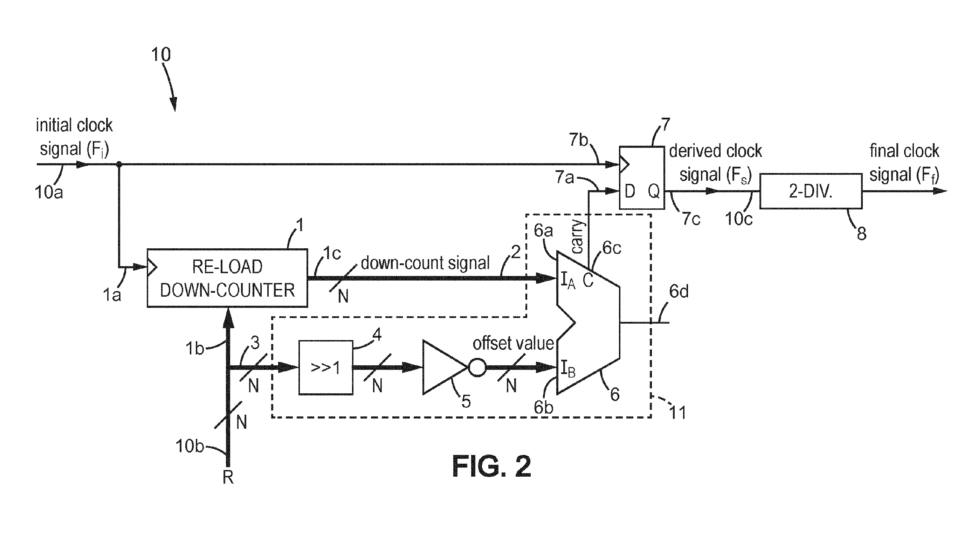

Figure 2 corresponds to Figure 1 for a preferred design of the digital combination 11, with the programmable re-load counter 1 being a down-counter. Additionally but independently, Figure 2 also illustrates an optional invention refinement which provides a further reduction of the synthesized frequency Fₛ.

The additional reference numbers used in Figure 2 have the following meanings:
4 digital shifter operating over N bits, and producing a one-bit shift of the bit values in right direction within the N-bit encoding, namely one-step shifting towards the lowest bit rank
5 bit-inverter operating separately over the N bits transmitted by the shifter 4
6 digital adder with N-bit adder inputs I_{A} and I_{B} respectively labelled 6a and 6b, N-bit adder output 6d, and carry output denoted C and labelled 6c
8 optional frequency two-divider, denoted 2-DIV.

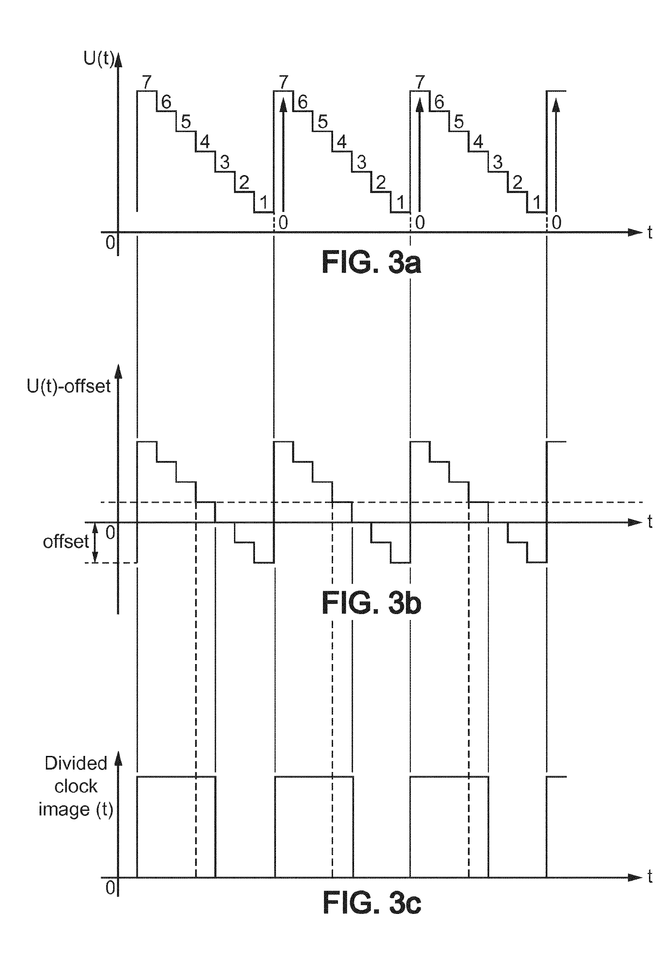

The counter 1 then transmits a digital down-count signal encoded over N-bits to the intermediate bus 2 which originates from the counter output 1c. The time-variations of the down-count signal are shown in Figure 3a. X-axis is time denoted t and Y-axis is the down-count signal denoted U(t). The down-count starts for example with value equal to R (7 in the example illustrated), and decreases gradually with unity decrement down to one-value. Once the one-value has been produced during one same reference cycle duration as for the other down-counted values, the down-count is repeated again from the R-value and so on. Count jumps from the one-value to the R-value thus form R-reloads of the down-count signal, indicated with vertical arrows. This down-count signal is clocked at the Fᵢ-frequency, due to the initial clock signal being fed into the counter input 1a. The down-count signal is then fed by the intermediate bus 2 into the adder input 6a.

Along the intermediate bus 3, the effect of the shifter 4 (Figure 2) is substantially equivalent to dividing the R-value by two: R>>1 equals R/2 for even R-values and (R-1)/2 for odd R-values. Then, the effect of the inverter 5 is calculating the number complementary to R>>1 with respect to 2^{N}-1: 2^{N}-1-(R>>1). This number is denoted offset value and fed into the input 6b of the adder 6.

The adder 6 is a N-bit adder which adds the bit values of same rank as received at inputs 6a and 6b, and further adds a carry value originating from the bit rank just below. The addition result encoded over N bits as produced at the adder output 6d is actually not used in the present invention embodiment. The carry output 6c of the N-bit adder 6 produces the carry value which originates from the highest rank bit addition. It forms the digital signal which is outputted by the digital combination 11, and equals zero as long as the N-bit addition result is comprised between zero and 2^{N}-1 included, and equals unity when the N-bit addition result is 2^{N} or more, or less than zero due to 2^{N}-modulo equivalence. Hence, the adder 6 also has a digital comparator function.

The time-diagram of Figure 3b corresponds to that of Figure 3a when a constant positive offset is subtracted from the down-count signal U(t). Time-diagrams 3a to 3c correspond to each other along vertical alignment. Figure 3c shows the signal which results from sign detection performed from the values exhibited in Figure 3b. Actually, the signal of Figure 3c, denoted "divided clock image" is equivalent to reporting the highest rank carry value as resulting from the addition of the down-count signal U(t) with the opposite of the offset. In the example illustrated, R equals 7. Generally, the synthesized frequency Fₛ of the divided clock image is the initial frequency Fᵢ divided by the R-value, as this appears from comparing Figures 3a and 3c.

The horizontal broken line in Figure 3b with the vertical broken lines connecting Figures 3b and 3c show that modifying the offset value leads to varying the duty cycle of the divided clock image.

According to the invention, the offset is determined automatically as a function of the division ratio value R, as being equal to 2^{N}-1 - (R>>1). Then, the duty cycle theoretically equals 50% for the even values of the division ratio R, and equals (R+1)/(2R) for the odd R-values. When the R-value is large, the duty cycle for the odd R-values almost equals 50% too.

The function of the D-flipflop 7 (Figures 1 and 2) is synchronizing the derived clock signal with respect to the initial clock signal. Using the design of Figure 2, the carry values successively produced by the adder 6 from output 6c are fed into the D-input 7a, and the initial clock signal is also fed into the synchronization input 7b. The Q-output 7c of the D-flipflop 7 thus delivers the derived clock signal synchronized with reference to the initial clock signal.

The table below exhibits the carry values which are successively obtained for the example with N=4 and R=7, corresponding to Figures 3a to 3c. These carry values form the derived clock signal for each stroke of the initial clock signal. Using these N- and R-values, (R>>1) = 3 and 2^{N}-1 - (R>>1) = 12.

| Down-count signal | Addition result (at adder output 6d, not used) | Carry value |
|---|---|---|
| 1 | 13 | 0 |
| 0: re-load to 7 | 19 modulo 16 = 3 | 1 |
| 6 | 18 modulo 16 = 2 | 1 |
| 5 | 17 modulo 16 = 1 | 1 |
| 4 | 16 modulo 16 = 0 | 1 |
| 3 | 15 | 0 |
| 2 | 14 | 0 |
| 1 | 13 | 0 |
| 0: re-load to 7 | 19 modulo 16 = 3 | 1 |
| 6 | 18 modulo 16 = 2 | 1 |

The last column leads to a duty cycle value equal to 4/7 = 0.57 for this example.

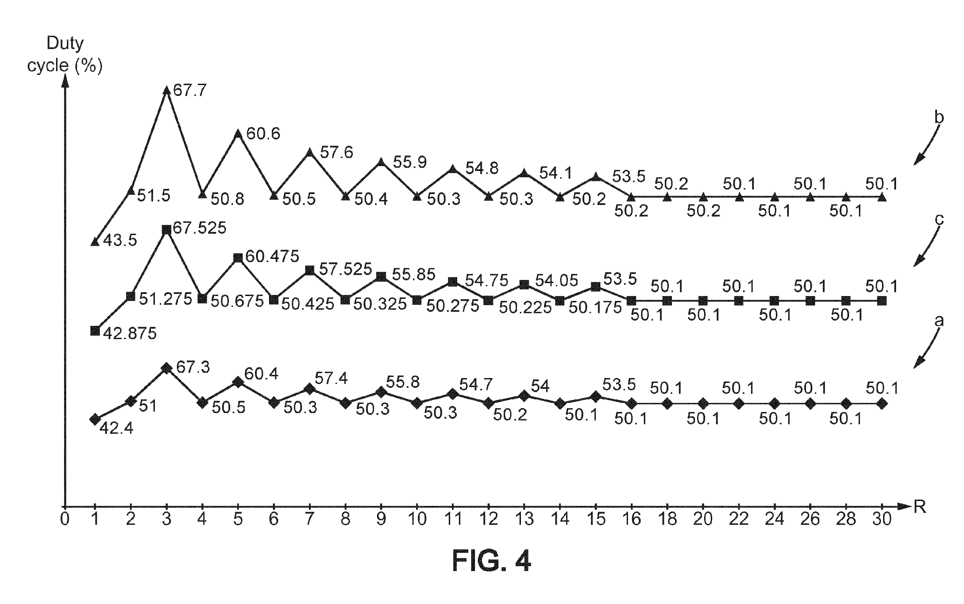

Figure 4 is a diagram indicating the duty cycle values which are obtained by using a frequency divider module according to Figure 2, where N-value is depending on the division ratio R. For each R-value indicated on the X-axis, the duty cycle has been measured while varying a module temperature and also a module supply voltage. The duty cycle values labelled "a" are the minimal ones thus obtained, those labelled "b" are the maximum ones, and those labelled "c" are the average values calculated when thus varying the temperature and the supply voltage. Very small variations in the duty cycle appear for each R-value, as this appears from comparing the a- and b-values.

Actually, the results shown in Figure 4 for R-values equal to one and two are not obtained using the invention. The case R=1 is just obtained by bypassing the frequency divider module so that the derived clock signal is almost identical to the initial clock signal. The case R=2 may be obtained by just inputting the initial clock signal into a frequency two-divider unit. In a basic well-known implementation, such frequency two-divider unit may be obtained by using a D-flipflop with the initial clock signal fed into its synchronization input, the data input D being back-fed from the inversed data output of the D-flipflop, and the non-inversed data output of the D-flipflop thus producing the derived clock signal with half the frequency of the initial clock signal.

Referring again to Figure 2, the frequency two-divider 8 may be arranged downstream the output 7c of the D-flipflop 7. Such frequency two-divider 8 then transforms the derived clock signal with synthesized frequency Fₛ as originating from the D-flipflop output 7c, into a final clock signal with frequency F_{f} equal to half the Fₛ-frequency. The two-divider 8 may be comprised itself of a further D-flipflop, as explained just above for the particular case of the division ratio value R equal to two.

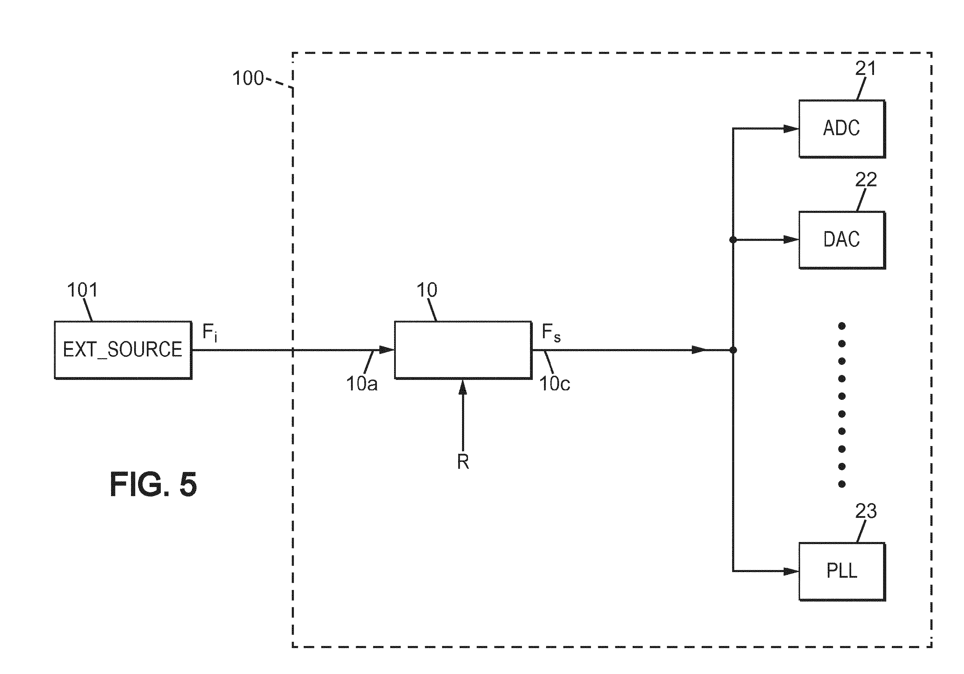

Figure 5 illustrates an implementation of the programmable frequency divider module 10 within an electronic circuit. The additional reference numbers indicated therein have the following meanings:
101 clock module denoted EXT_SOURCE, and suitable for delivering the initial clock signal with the initial frequency Fᵢ
100 in-chip circuitry
21 analog-to-digital converter, denoted ADC
22 digital-to-analog converter, denoted DAC
23 phase-locked loop device, denoted PLL

The clock module 101 may be of any type. In some implementations, it may be external to a circuit chip which contains the analog-to-digital converter 21, the digital-to-analog converter 22 and the phase-locked loop device 23 in integrated form. For example, the clock module 101 may be based on a crystal contained within a separate circuit component. Obviously, the above-listed circuit blocks 21 to 23 are listed for exemplifying purpose only, and may be replaced with other circuit blocks, whatever their number.

Possibly, the in-chip circuitry 100 may be provided as well with several programmable frequency divider modules, which are each fed with the initial clock signal by the clock module 101, but each programmed with a different value for its respective division ratio R. Thus, each programmable frequency divider module so-provided is capable of clocking separate sets of circuit blocks within the in-chip circuitry.

Also, an additional frequency two-divider similar to that referenced 8 above, may be arranged between some of the circuit blocks and the clock output 10c of the corresponding programmable frequency divider module 10.

## Claims

1. Programmable frequency divider module (10) comprising:
- a clock input (10a) intended for receiving an initial clock signal having an initial frequency (Fᵢ);
- a ratio input (10b) intended for receiving an integer division ratio value (R) greater than two; and
- a clock output (10c) for delivering a derived clock signal having a synthesized frequency (Fₛ) equal to the initial frequency (Fᵢ) divided by the division ratio value (R);
further comprising, N being an integer greater than unity:
- a programmable re-load counter (1) connected at counter inputs (1 a, 1 b) respectively to the clock input (10a) and the ratio input (10b), and adapted for outputting repeatedly an integer count signal running between the one-value and the division ratio value (R), said values included, and the count signal being clocked according to the initial clock signal;
- a first intermediate N-bus (2) arranged for forwarding the count signal encoded over N bits;
- a second intermediate N-bus (3) connected at entrance to the ratio input (10b) for receiving the division ratio value (R) encoded over N bits;
- a digital combination (11) comprising an N-bit adder, with first (11 a) and second (11 b) inputs of the digital combination connected respectively to exits of the first (2) and second (3) intermediate N-buses, and the digital combination being suitable for delivering at output a digital signal comprised alternatively of one out of two values depending on a comparison between at least one threshold and a result of an addition performed by the N-bit adder based on the count signal; and
- a D-flipflop (7) having a data input (7a), a synchronization input (7b) and a flipflop output (7c), with said data input connected to an output of the digital combination (11) for receiving the digital signal, said synchronization input connected to the clock input (10a), and said flipflop output (7c) connected to the clock output (10c).

2. Programmable frequency divider module (10) according to Claim 1, wherein the digital combination (11) comprises, further to the N-bit adder, at least one among a x-bit-right shifter, a y-bit-left shifter, a N-inverter and a digital comparator, x and y being non-zero integers less than N.

3. Programmable frequency divider module (10) according to Claim 1 or 2, wherein the programmable re-load counter (1) is a programmable re-load down-counter, so that the count signal is a down-count signal decreasing from the division ratio value (R) and repeating back from said division ratio value after the one-value has been reached.

4. Programmable frequency divider module (10) according to Claims 2 and 3, wherein a first adder input (6a) of the N-bit adder (6) is connected to the exit of the first intermediate N-bus (2), and the digital combination (11) comprises further to said N-bit adder:
- a 1-bit-right shifter (4) connected at input to the exit of the second intermediate N-bus (3); and
- an N-inverter (5) connected downstream the shifter (4), and adapted for inverting each bit separately as originating from said shifter, said N-inverter thus producing an offset value and being connected at output to the second adder input (6b),
so that the N-bit adder (6) adds the down-count signal to the offset value.

5. Programmable frequency divider module (10) according to Claim 4, wherein the N-bit adder (6) is provided with a carry output (6c) for delivering a carry forming the digital signal, said carry equalling a first value when the addition result of the down-count signal with the offset value is less than 2N, and otherwise equalling a second value different from said first value.

6. Programmable frequency divider module (10) according to any one of the preceding claims, further comprising a frequency two-divider unit (8) connected at input to the clock output (10c), and suitable for producing a final clock signal based on the derived clock signal, and said final clock signal having a final frequency (F_{f}) equal to half the synthesized frequency (Fₛ).

7. Electronic circuit comprising:
- a clock module (101) adapted for producing an initial clock signal having an initial frequency (Fᵢ);
- at least one programmable frequency divider module (10) according to any one of the preceding claims, with the clock input (10a) connected to the clock module (101) for receiving the initial clock signal; and
- at least one circuit block (21-23) connected to the clock output (10c) of the programmable frequency divider module (10), so that said circuit block is clocked based on the derived clock signal.

8. Electronic circuit according to Claim 7, wherein the programmable frequency divider module (10) and the circuit block (21-23) are contained within one and same integrated circuit chip (100), and the clock module (101) is external to said chip.

9. Electronic circuit according to Claim 7 or 8, wherein the circuit block (21-23) is selected from an analog-to-digital converter, a digital-to-analog converter and a phase-locked loop device.
